(19) Europäisches Patentamt
European Patent Office
Office européen des brevets

(11) **EP 4 575 520 B1**

(12) **EUROPEAN PATENT SPECIFICATION**

(45) Date of publication and mention
of the grant of the patent:
**06.05.2026 Bulletin 2026/19**

(21) Application number: **23220062.6**

(22) Date of filing: **22.12.2023**

(51) International Patent Classification (IPC):
***G01R 1/20*** (2006.01)     ***G01R 31/364*** (2019.01)

(52) Cooperative Patent Classification (CPC):
**G01R 1/203;** G01R 31/364

(54) **CURRENT TRANSDUCER WITH SHUNT**

STROMWANDLER MIT SHUNT

TRANSDUCTEUR DE COURANT À SHUNT

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(43) Date of publication of application:
**25.06.2025 Bulletin 2025/26**

(73) Proprietor: **LEM International SA
1217 Meyrin (CH)**

(72) Inventor: **TROMBERT, Stéphan
74320 Leschaux (FR)**

(74) Representative: **reuteler & cie SA
Chemin de la Vuarpillière 29
1260 Nyon (CH)**

(56) References cited:
**EP-A1- 3 851 859**     **EP-B1- 2 981 833**
**WO-A1-2021/014872**     **DE-A1- 102019 218 308**
**DE-A1- 102021 210 139**     **DE-B3- 102020 111 634**
**DE-T5- 112019 004 609**     **US-A1- 2017 089 955**

Remarks:
The file contains technical information submitted
after the application was filed and not included in this
specification

## Description

The present invention relates to a current transducer based on a shunt resistor.

One of the known shunt transducer configurations, in particular for high current applications, comprises a bus bar, typically in the form of a rectangular profiled bar configured to be clamped or otherwise connected to a primary conductor carrying the current to be measured. The bus bar typically has a section of a shunt material such as Manganin - a copper, manganese, nickel alloy - integrally formed and connected to the copper bus bar on either end, whereby the resistance across the shunt material section is measured. The shunt material Manganin is used because of it's low temperature coefficient of resistance value and it's long term stability. Thus, there is a higher measurement accuracy over a large range of temperatures compared to copper or other metals and alloys.

It is known to position one or two contacts on the copper sections of the bus bar bordering the shunt section, to pick up the voltage across the shunt section and determine the current flowing through the shunt section. Depending on the frequency and amplitude of the electrical current, the one or two terminals on each border of the shunt section may not allow to optimally measure the primary current to be measured in a precise manner.

In many applications, for instance in the automotive field, it is important for safety and reliability reasons to have a redundant measurement signal, which generally requires a second current transducer. This however increases costs and takes space, and may also affect reliability due to the increased number of components.

In view of the foregoing, it is an object of this invention to provide a shunt current transducer that is safe and reliable, yet economical.

It is advantageous to provide a shunt current transducer that is precise over a large range of operating conditions.

It is advantageous to provide a shunt current transducer that is compact.

It is advantageous, for certain applications, to provide a shunt current transducer that is adapted for the measurement of high currents and has the form of a bus bar that may be coupled to standard circuits provided with bus bar terminal connections.

Various current transducers comprising a shunt resistor or resistive measurement conductor section are described in US2017/089955, DE102019218308, EP3851859, DE 102021210139, WO2021/014872, DE112019004609, EP2981833, and DE102020111634B3.

Objects of this invention have been achieved by providing a system according to claim 1. Dependent claims set forth various advantageous features of embodiments of the invention.

Disclosed herein is a shunt current transducer comprising a primary conductor including a busbar portion with a substantially rectangular cross section, and a measurement processing unit mounted against and connected to the primary conductor, the measurement processing unit comprising a circuit board and a signal processing circuit on the circuit board.

The primary conductor comprises a plurality of shunt sections connected in series, including at least a first shunt section and a second shunt section, each shunt section bounded by a terminal set arranged at each end of the respective shunt section, said terminal sets comprising terminals formed on the circuit board, the signal processing circuit comprising a first measurement channel connected to the first shunt section and a second measurement channel connected to the second shunt section.

The first and second shunt sections are directly adjacent each other and comprise a terminal set that forms the interface between the adjacent first and second shunt sections.

In an embodiment, the first measurement channel comprises a first integrated circuit chip connected to the terminal sets at ends of the first shunt section, and a second integrated circuit chip connected to the terminal sets at ends of the second shunt section.

In an embodiment, the signal processing circuit is configured to cross check measurement values between the first measurement channel and the second measurement channel.

In an embodiment, the material of the first shunt section is different from the material of the second shunt section.

In an embodiment, the material of the first shunt section comprises or consists of a Cu-Ni-Mn alloy, preferably Manganin.

In an embodiment, the material of the second shunt section (4b) is the main material forming the primary conductor.

In an embodiment, the main material forming the primary conductor comprises an alloy with copper of more than 90%, or comprises a copper aluminium alloy.

In an embodiment, at least one of the terminal sets comprises a plurality of terminals greater than five distributed across the width of the associated shunt section substantially in a line.

In an embodiment, the plurality of terminals of a terminal set are spaced part evenly from each other.

In an embodiment, all of the terminal sets comprise a plurality of connection terminals greater than five distributed across the width of the respective shunt sections, orthogonal to the direction of flow of the primary current through the shunt sections.

In an embodiment, for one or at least one shunt section, each shunt terminal is connected to a resistance, said resistances being connected in parallel to an input of the measurement channel, configured to measure an average value of the voltage difference between ends of the one or at least one shunt section and to determine therefrom the primary current flowing through the one or at least one shunt section.

In an embodiment, the shunt terminals comprise conductive pads formed on the circuit board soldered to the primary conductor.

In an embodiment, the signal processing circuit comprises a temperature sensor on the circuit board, connected thermally through a metallic via to the primary conductor.

In an embodiment, the temperature sensor is positioned between terminal sets of one or at least one of the shunt sections.

In an embodiment, the temperature sensor is positioned substantially centrally between said terminal sets of one or at least one of the shunt sections.

In an embodiment, the primary conductor comprises transducer terminals configured for a mechanical connection to corresponding terminals of an external primary conductor.

In an embodiment, the primary conductor comprises a third shunt section connected in series to the first and second shunt sections.

In an embodiment, the third shunt section has the same material as the second shunt section, and a different material from the first shunt section which is arranged between the second and third shunt sections.

Further objects and advantageous features of the invention will be apparent from the claims, from the detailed description, and annexed drawings, in which:

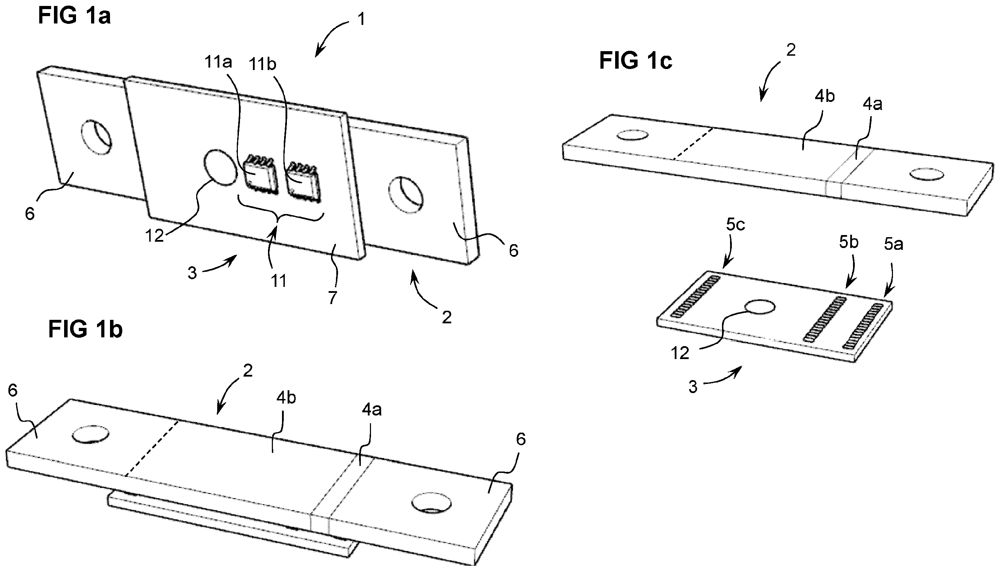

> Figures 1a and 1b are perspective views of a shunt current transducer according to an embodiment of the invention;
> Figure 1c is an exploded view of the embodiment of figures 1a, 1b;
> Figure 2a is schematic block diagram of a measurement processing unit of a shunt current transducer according to an embodiment of the invention;
> Figures 2b and 2c are a schematic circuit diagrams of the measurement processing unit connected to a primary conductor of a current transducer according to an embodiment of the invention;
> Figure 3a is a perspective view of a primary conductor of a shunt current transducer according to another embodiment of the invention;
> Figure 3b is a perspective view of a primary conductor according to yet another variant of a shunt current transducer according to an embodiment of the invention;
> Figure 4a is a perspective view of a shunt current transducer according to an embodiment of the invention;
> Figure 4b is an exploded view of the shunt current transducer of figure 4a;
> Figure 4c is a bottom view of the shunt current transducer of figure 4a with the housing removed.

Referring to the figures, a shunt current transducer 1 according to embodiments of the invention comprises a primary conductor 2 and a measurement processing unit 3 connected to the primary conductor 2 comprising at least a first measurement channel "channel 1" and a second measurement channel "channel 2".

The primary conductor 2 has a plurality of shunt sections 4 including at least a first shunt section 4a and a second shunt section 4b.

The measurement processing unit is configured in the first measurement channel to measure a voltage of the first shunt section of the primary conductor and output therefrom a measurement signal representative of a primary current flowing in the primary conductor 2, and the measurement processing unit is configured in the second measurement channel to measure a voltage of the second shunt section of the primary conductor and output therefrom a measurement signal representative of a primary current flowing in the primary conductor 2.

The primary conductor 2 may in particular have a form of a bus bar, in particular a rectangular cross section bus bar.

Ends of the shunt sections are connected to and defined by shunt terminals 5 (5a, 5b, 5c, 5d).

In an embodiment, the second shunt section 4b is directly adjacent the first shunt section 4a. In such embodiment, there may be only three sets of shunt terminals, comprising a first terminal set 5a at a first end of the first shunt section 4a, a second terminal set 5b at an opposed second end of the first shunt section 4a and concurrently at a first end of the second shunt section, and a third terminal set 5c at an opposing second end of the second shunt section.

In another embodiment, the second shunt section 4b may be spaced apart from the first shunt section 4a by a section of primary conductor such that the first shunt section is bounded by first and second terminal sets 5a, 5b and the second shunt section is bounded by third and fourth terminal sets 5c, 5d.

It is however more economical to provide only three terminals sets and therefore to have the second shunt section 4b directly adjacently first shunt section 4a.

The first shunt section 4a may, in an advantageous embodiment, comprise a material that is different to the material of the second shunt section 4b. However, within the scope of the invention, the second shunt section 4b may comprise a material that is the same as the material of the first shunt section 4a.

The material of the first shunt 4a is preferably a material with a low temperature coefficient of resistance value, in particular a Copper Manganese Nickel (Cu-Mn-Ni) alloy such as Manganin (Cu84/Mn12/Ni4 or Cu86/Mn12/Ni2) or Copper Nickel (Cu-Ni) alloy Constantan (Cu55/ /Ni35), that are well known for use in shunt resistors because of their properties of very low temperature coefficient of resistance value. Other materials with low temperature coefficient of resistance values such as certain nickel-chromium alloys NiCr may also be advantageously implemented.

If the second shunt section is of a different material than the first shunt section, the second shunt section 4b may consist of a material that forms the principal material of the primary conductor, for instance a substantially copper or copper alloy material that is commonly used for bus bars, or alternatively an aluminium alloy. Materials with low temperature coefficient of resistance values such as Maganin are expensive and are usually placed between common copper parts for mechanical and electrical integrity. Therefore, the use of the material that forms the principal material of the primary conductor, for instance a substantially copper or copper alloy material that is commonly used for bus bars, is advantageous from a cost and mechanical properties perspective. The lower cost typical bus bar material parts results in a lower accuracy shunt measurement, but is accurate enough to provide a redundant channel for functional safety applications.

If the second and first shunt sections are of the same material, the first and second shunt sections being defined by the terminal sets that are at the boundaries of the shunt sections, then the shunt sections material is preferably a material with a low temperature coefficient of resistance value as previously mentioned.

In a preferred embodiment however the shunt sections comprise Manganin for the first shunt section which allows to provide a very precise measurement of the voltage (and therefrom the primary current) over a given range of temperatures, the other shunt section formed simply by the main material forming the primary conductor, in particular copper or principally copper based alloy. In this embodiment, although the second shunt section does not provide as precise a measurement output as the first shunt section over a given range of temperatures, it is sufficiently accurate to provide a redundant measurement signal that allows to verify the measurement signal measured across the first shunt section and thus to provide a redundant safety signal to detect malfunction.

Some or all of the sets of shunt terminals 5 may advantageously comprise a plurality of contact terminals greater than five that span across most of the width of the primary conductor, preferably substantially evenly spaced from each other. There may for instance be a plurality in a range of 5 to 15 terminals in each of one or more more terminal sets.

The plurality of contact terminals of a set that span across the width of the primary conductor, allow to capture the primary current flowing in the primary conductor at different positions distributed across the width of the primary conductor to thus capture a more accurate representation of the mean primary current flowing through the shunt resistance. Measurement inaccuracy stemming from one or two local measurement points in a situation of uneven current density across the width of the primary conductor is thus mitigated.

Measurement inaccuracies due to uneven current density across the width of the primary conductor is more likely to occur in the material that forms the principal material of the primary conductor, for instance a substantially copper or copper alloy material that is commonly used for bus bars, whereas in materials with low temperature coefficient of resistance values such as Maganin which have a higher resistivity than standard bus bar materials, the current density across the conductor is more homogeneous. For this reason, if Manganin or other high resistance conductor materials are used for the shunt section, it may be sufficient to have only one or two terminals on each side of the shunt section, whereas for lower resistivity materials such as common copper alloys for bus bars, it is advantageous to provide the terminal sets on each side of the shunt section with a plurality of contact terminals greater than five, spread across the width of the shunt section.

In an advantageous embodiment, the shunt terminals comprise solder pads on the circuit board soldered at corresponding discrete points to the primary conductor, for instance by reflow soldering. Reflow soldering may be performed in a standard soldering process for SMD components. The solder pads are separated from each other and the voltages present on those pads are separate inputs to the analog frontends for processing.

In variants, the plurality of terminals of the terminal set may comprise individual pin terminals that are welded or soldered on to the surface of the primary conductor, or that are inserted with an interference fit in corresponding terminal receiving cavities formed in the primary conductor.

The terminal sets 5a, 5b arranged at ends of the first shunt section 4a, are preferably connected to the main material of the primary conductor at the interface (border) with the first shunt section, rather than connected directly to the material with a low temperature coefficient of resistance value of the first shunt section 4a.

The measurement processing unit 3 comprises the circuit board 7 and a signal processing circuit 8 on the circuit board 7. The circuit board 7 may have conductive pads forming the terminal sets 5 (5a, 5b, 5c, 5d) bounding the first and second shunt sections.

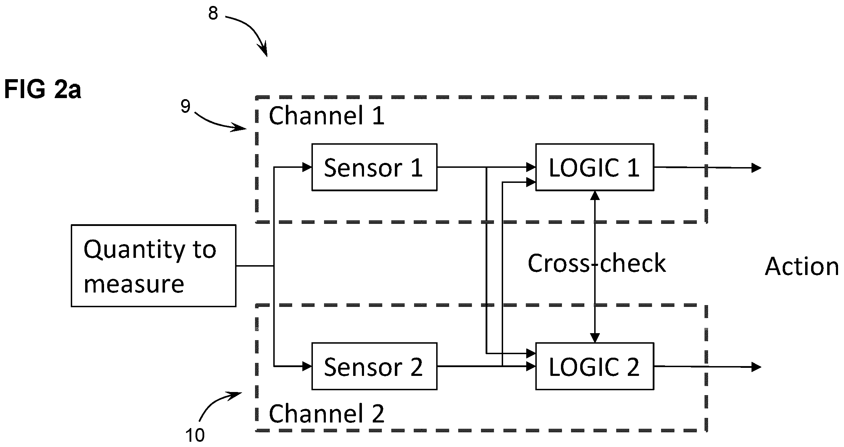

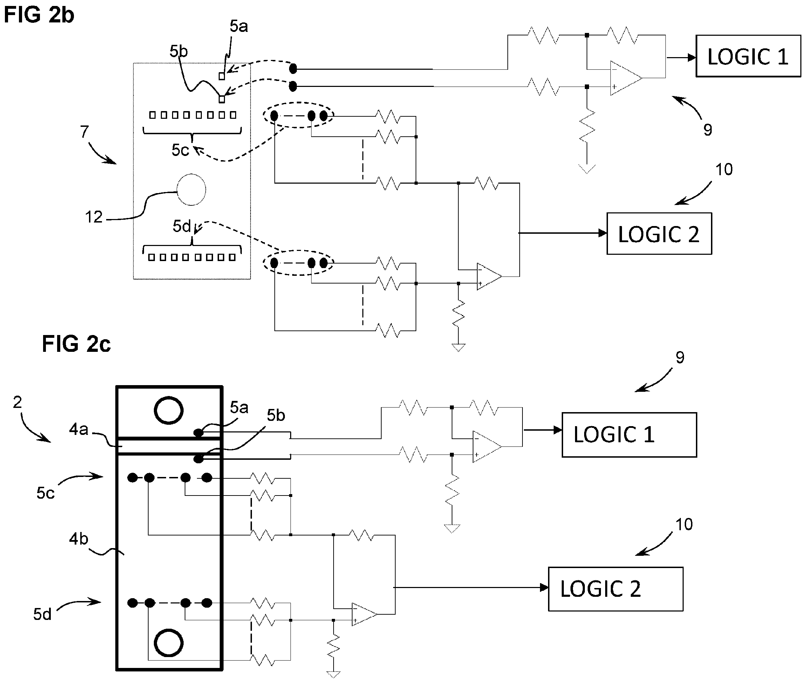

The terminal sets 5 may comprise circuit pads on the circuit board that are connected in parallel via individual resistors as illustrated in the circuit diagram of figure 2b.

The current transducer may further comprise at least one temperature sensor 12 configured to measure a temperature of at least one of the shunt sections, to adjust the current measurement value as a function of the measured temperature. The temperature sensor may for instance be mounted on the circuit board on a side opposite the side on which the primary conductor is mounted, and thermally connected thereto with a metallic via through the circuit board, soldered to the primary conductor. The temperature sensor and via connection is preferably positioned between the first and second terminal sets, for instance approximately at a mid-point 12a between the terminal sets of the corresponding shunt section.

For a shunt section with a plurality of contact terminals spread across the width of the shunt section as mentioned above, the measurement of primary current may be performed as follows:

The voltages of the first terminal set 5b are averaged to obtain an average voltage value $AV_A$, and the voltages of the second terminal set 5c are averaged to obtain an average voltage value $AV_B$. The temperature *"Temp"* of the shunt section may be measured between the first and second terminal sets, for instance approximately at a mid-point between the terminal sets.

The current measurement could be obtained with a formula of the form:

$$Current = \frac{(A * AV_A + B * AV_B)}{(C * Temp + D)}$$

With *A, B, C, D* coefficients calculated during calibration. Further corrections could be done by reference to lookup tables for instance.

As mentioned, the signal processing circuit 8 comprises a first measurement channel 9 and a second measurement channel 10, the first measurement channel 9 comprising circuitry for measuring the resistance of the first shunt section 4a, and the second measurement channel 10 comprising circuitry for measuring the resistance of the second shunt section 4b. Circuitry for measuring a shunt resistance is *per se* well known. In the present invention however, each shunt section 4a, 4b provides an independent measurement output. The measurement output of the first channel comprises a measurement of the shunt resistance of the first shunt section 4a processed in a first logic circuit (logic 1) and the measurement output of the second channel comprises a measurement of the shunt resistance of the second shunt section 4b processed in a second logic circuit (logic 2). The first logic circuit is separate from the second logic circuit but the two logic circuits may be interconnected to cross-check the measurement outputs from the logic circuit 1 and the logic circuit 2 in order to determine a malfunction of one of the output circuits.

The logic circuits may be formed in integrated circuit (IC) chips, Each measurement channel may comprise its own integrated circuit chip, the first measurement channel 9 having a first IC chip 11a and the second measurement channel 10 having a second IC chip 11b. The separate IC chips, one for each measurement channel, provide greater independence between the two channels and therefore a higher safety. Both IC chips may be mounted and interconnected to the same circuit board 7. The circuit board may be assembled along, adjacent and against the primary conductor bus bar 2 and have a width that is substantially the same, or within 20% greater or smaller than the primary conductor width so as to form a compact current transducer arrangement.

The primary conductor may be provided with transducer terminals 6 for instance in a form of holes as well known for clamping on a bolt and nut connection. However other *per se* well known interconnection methods, with or without the provision of holes, for instance by clamping welding, or soldering, may be provided in variants.

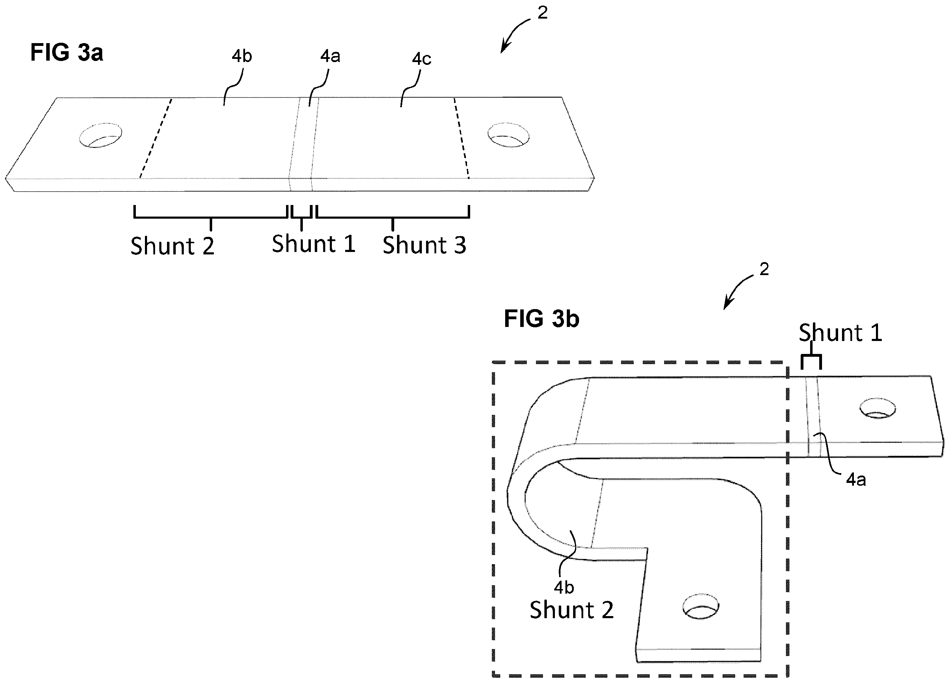

Yet further redundancy may be provided by including in the primary conductor a third shunt section 4c as schematically illustrated in the embodiment of figure 3a.

The primary conductor may have a non-planar shape, for instance with a bent section, and where the transducer terminals 6a, 6b are not necessarily aligned, for instance as illustrated in figure 3b. Various configurations of the bus bar may be provided to adapt to the devices and primary conductor configuration of the device to which they are intended to be coupled.

One or a plurality of the current transducers may be integrated directly within an electrical system of a device with one or more electrical phases, or may be provided as an individual component for assembly and connection to external devices.

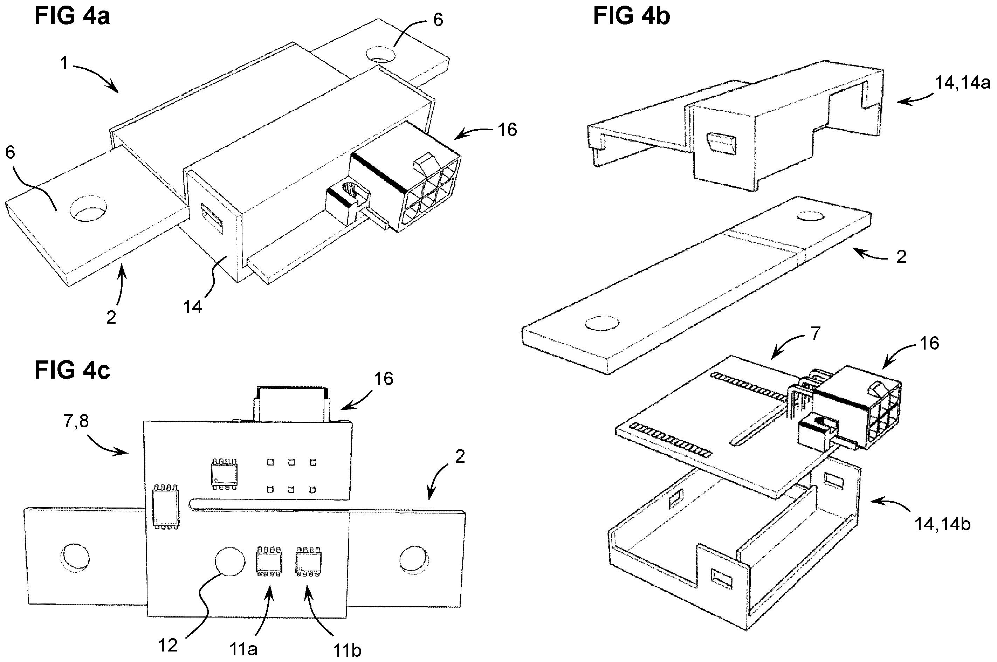

In figures 4a to 4c, an example of the current transducer 1 provided as an individual component is illustrated. In this particular example, the current transducer comprises an insulating housing 14 surrounding the shunt sections and portion of the circuit board mounted against the shunt sections, and a connector 16 for pluggable connection to a connector of an external device for power and measurement signal communication. The current transducer may advantageously be implemented in a battery current measurement system, for instance of an electric vehicle.

*List of references used*

**Shunt current transducer 1**

**Primary conductor 2**

Bus bar
Shunt sections 4

First shunt section 4a
Second shunt section 4b
Third shunt section 4c

Transducer terminals 6

**Shunt terminals 5**

First terminal set 5a
Second terminal set 5b

Third terminal set 5c
Fourth terminal set 5d

**Measurement processing unit 3**

**Circuit board 7**
**Signal processing circuit 8**

**First measurement channel 9**

*Inputs:*

*First terminal set 5a*
*Second terminal set 5b*

Connection points
Resistors
Operational ampliflier
First IC chip 11a

**Second measurement channel 10**

*Inputs:*

*Second terminal sets 5b*
*Third terminal sets 5c*

Resistors
Operational ampliflier
Second IC chip 11b

(Third measurement channel)
**Integrated circuit (IC) chip(s) 11**

*First IC chip 11a*
*Second IC chip 11b*

**Temperature sensor 12**

**Housing 14**
**Connector 16**

**Claims**

1. A shunt current transducer (1) comprising a primary conductor (2) including a busbar portion with a substantially rectangular cross section, and a measurement processing unit (3) mounted against and connected to the primary conductor, the measurement processing unit (3) comprising a circuit board (7) and a signal processing circuit (8) on the circuit board, the primary conductor comprising a plurality of shunt sections (4) connected in series, including at least a first shunt section (4a) and a second shunt section (4b), each shunt section bounded by a terminal set (5) arranged at each end of the respective shunt section, said terminal sets comprising terminals formed on the circuit board (7), the signal processing circuit (8) comprising a first measurement channel (9) connected to the first shunt section (4a), and a second measurement channel (10) connected to the second shunt section (4b), **characterized in that** the first and second shunt sections are directly adjacent each other and comprise a terminal set that forms the interface between the adjacent first and second shunt sections.

2. The shunt current transducer according to claim 1 wherein the first measurement channel (9) comprises a first integrated circuit chip (11a) connected to the terminal sets at ends of the first shunt section (4a), and a second integrated circuit chip (11b) connected to the terminal sets at ends of the second shunt section (4b).

3. The shunt current transducer according to any preceding claim wherein the signal processing circuit is configured to cross check measurement values between the first measurement channel and the second measurement channel.

4. The shunt current transducer according to any preceding claim wherein the material of the first shunt section is different from the material of the second shunt section.

5. The shunt current transducer according to any preceding claim wherein the material of the first shunt section (4a) comprises or consists of a Cu-Ni-Mn alloy, preferably Manganin.

6. The shunt current transducer according to any preceding claim wherein the material of the second shunt section (4b) is the main material forming the primary conductor.

7. The shunt current transducer according to the preceding claim wherein the main material forming the primary conductor comprises an alloy with copper of more than 90%, or comprises a copper aluminium alloy.

8. The shunt current transducer according to any preceding claim wherein at least one of the terminal sets comprises a plurality of terminals greater than five distributed across the width of the associated shunt section substantially in a line.

9. The shunt current transducer according to the preceding claim wherein the plurality of terminals of a terminal set are spaced part evenly from each other.

10. The shunt current transducer according to either of the two directly preceding claims wherein all of the terminal sets comprise a plurality of connection terminals greater than five distributed across the width of the respective shunt sections, orthogonal to the direction of flow of the primary current through the shunt sections.

11. The shunt current transducer according to any of the three directly preceding claims wherein each shunt terminal is connected to a resistance, said resistances being connected in parallel to an input of the respective measurement channel.

12. The shunt current transducer according to any preceding claim wherein the shunt terminals comprise conductive pads formed on the circuit board soldered to the primary conductor.

13. The shunt current transducer according to any preceding claim wherein the primary conductor comprises transducer terminals (6) configured for a mechanical connection to corresponding terminals of an external primary conductor.

14. The shunt current transducer according to any preceding claim wherein primary conductor comprises a third shunt section (4c) connected in series to the first and second shunt sections (4a, 4b), optionally wherein the third shunt section has the same material as the second shunt section, and a different material from the first shunt section which is arranged between the second and third shunt sections.

**Patentansprüche**

1. Nebenschlussstromwandler (1), der einen primären Leiter (2), der einen Sammelschienenabschnitt mit einem im Wesentlichen rechteckigen Querschnitt beinhaltet, sowie eine Messungsverarbeitungseinheit (3) umfasst, die am primären Leiter montiert und mit demselben verbunden ist, wobei die Messungsverarbeitungseinheit (3) eine Leiterplatte (7) und eine Signalverarbeitungsschaltung (8) auf der Leiterplatte umfasst, wobei der primäre Leiter eine Vielzahl von Nebenwiderstandsbereichen (4) umfasst, die in Reihe verbunden sind und mindestens einen ersten Nebenwiderstandsbereich (4a) und einen zweiten Nebenwiderstandsbereich (4b) beinhalten, wobei jeder Nebenwiderstandsbereich durch einen Anschlusssatz (5) gekoppelt ist, der an jedem Ende des jeweiligen Nebenwiderstandsbereichs angeordnet ist, wobei die Anschlusssätze Anschlüsse umfassen, die auf der Leiterplatte (7) gebildet sind, wobei die Verarbeitungsschaltung (8) einen ersten Messkanal (9), der mit dem ersten Nebenwiderstandsbereich (4a) verbunden ist, sowie einen zweiten Messkanal (10) umfasst, der mit dem zweiten Nebenwiderstandsbereich (4b) verbunden ist, **dadurch gekennzeichnet, dass** der erste und der zweite Nebenwiderstandsbereich einander direkt benachbart sind und einen Anschlusssatz umfassen, der die Schnittstelle zwischen dem ersten und dem zweiten benachbarten Nebenwiderstandsbereich bildet.

2. Nebenschlussstromwandler nach Anspruch 1, wobei der erste Messkanal (9) einen ersten integrierten Schaltungschip (11a), der mit den Anschlusssätzen an Enden des ersten Nebenwiderstandsbereichs (4a) verbunden ist, sowie einen zweiten integrierten Schaltungschip (11b) umfasst, der mit den Anschlusssätzen an Enden des zweiten Nebenwiderstandsbereichs (4b) verbunden ist.

3. Nebenschlussstromwandler nach einem der vorhergehenden Ansprüche, wobei die Signalverarbeitungsschaltung dazu ausgelegt ist, Messwerte zwischen dem ersten Messkanal und dem zweiten Messkanal zu überprüfen.

4. Nebenschlussstromwandler nach einem der vorhergehenden Ansprüche, wobei sich das Material des ersten Nebenwiderstandsbereichs vom Material des zweiten Nebenwiderstandsbereichs unterscheidet.

5. Nebenschlussstromwandler nach einem der vorhergehenden Ansprüche, wobei das Material des ersten Nebenwiderstandsbereichs (4a) eine Cu-Ni-Mn-Legierung, vorzugsweise Manganin, umfasst oder aus derselben besteht.

6. Nebenschlussstromwandler nach einem der vorhergehenden Ansprüche, wobei das Material des zweiten Nebenwiderstandsbereichs (4b) das Hauptmaterial ist, aus dem der primäre Leiter gebildet ist.

7. Nebenschlussstromwandler nach dem vorhergehenden Anspruch, wobei das Hauptmaterial, aus dem der primäre Leiter gebildet ist, eine Legierung mit Kupfer von mehr als 90% oder eine Kupfer-Aluminium-Legierung umfasst.

8. Nebenschlussstromwandler nach einem der vorhergehenden Ansprüche, wobei mindestens einer der Anschlusssätze eine Vielzahl von Anschlüssen umfasst, die, verteilt über die Breite des zugehörigen Nebenwiderstandsbereichs im Wesentlichen in einer Linie, größer ist als fünf.

9. Nebenschlussstromwandler nach dem vorhergehenden Anspruch, wobei die Vielzahl von Anschlüssen eines Anschlusssatzes gleichmäßig voneinander beabstandet sind.

10. Nebenschlussstromwandler nach einem der zwei direkt vorhergehenden Ansprüche, wobei alle Anschlusssätze eine Vielzahl von Verbindungsanschlüssen umfassen, die, verteilt über die Breite der jeweiligen Nebenwiderstandsbereiche senkrecht zur Fließrichtung des Primärstroms durch die Nebenwiderstandsbereiche, größer ist als fünf.

11. Nebenschlussstromwandler nach einem der drei direkt vorhergehenden Ansprüche, wobei jeder Nebenwiderstandsanschluss mit einem Widerstand verbunden ist, wobei die Widerstände parallel mit einem Eingang des jeweiligen Messkanals verbunden sind.

12. Nebenschlussstromwandler nach einem der vorhergehenden Ansprüche, wobei die Nebenwiderstandsanschlüsse leitende Auflagen umfassen, die auf der Leiterplatte gebildet und an den primären Leiter gelötet sind.

13. Nebenschlussstromwandler nach einem der vorhergehenden Ansprüche, wobei der primäre Leiter Wandleranschlüsse (6) umfasst, die für eine mechanische Verbindung mit entsprechenden Anschlüssen eines externen primären Leiters ausgelegt sind.

14. Nebenschlussstromwandler nach einem der vorhergehenden Ansprüche, wobei ein primärer Leiter einen dritten Nebenwiderstandsbereich (4c) umfasst, der mit dem ersten und dem zweiten Nebenwiderstandsbereich (4a, 4b) in Reihe verbunden ist, wahlweise wobei der dritte Nebenwiderstandsbereich dasselbe Material aufweist wie der zweite Nebenwiderstandsbereich und ein anderes Material aufweist als der erste Nebenwiderstandsbereich, der zwischen dem zweiten und dem dritten Nebenwiderstandsbereich angeordnet ist.

**Revendications**

1. Transducteur de courant shunt (1) comprenant un conducteur primaire (2) comportant une partie de barre omnibus avec une section transversale sensiblement rectangulaire et une unité de traitement de mesure (3) montée contre le conducteur primaire et connectée à celui-ci, l'unité de traitement de mesure (3) comprenant une carte de circuit imprimé (7) et un circuit de traitement de signal (8) sur la carte de circuit imprimé, le conducteur primaire comprenant une pluralité de sections shunt (4) connectées en série, comportant au moins une première section shunt (4a) et une deuxième section shunt (4b), chaque section shunt étant délimitée par un ensemble de bornes (5) agencées à chaque extrémité de la section shunt respective, lesdits ensembles de bornes comprenant des bornes formées sur la carte de circuit imprimé (7), le circuit de traitement de signal (8) comprenant un premier canal de mesure (9) connecté à la première section shunt (4a), et un deuxième canal de mesure (10) connecté à la deuxième section shunt (4b), **caractérisé en ce que** les première et deuxième sections shunt sont directement adjacentes l'une à l'autre et comprennent un ensemble de bornes formant l'interface entre les première et deuxième sections shunt adjacentes.

2. Transducteur de courant shunt selon la revendication 1, dans lequel le premier canal de mesure (9) comprend une première puce de circuit intégré (11a) connectée aux ensembles de bornes aux extrémités de la première section shunt (4a), et une deuxième puce de circuit intégré (11b) connectée aux ensembles de bornes aux extrémités de la deuxième section shunt (4b).

3. Transducteur de courant shunt selon l'une des revendications précédentes, dans lequel le circuit de traitement de signal est configuré pour vérifier par recoupement des valeurs de mesure entre le premier canal de mesure et le deuxième canal de mesure.

4. Transducteur de courant shunt selon l'une des revendications précédentes, dans lequel le matériau de la première section shunt est différent du matériau de la deuxième section shunt.

5. Transducteur de courant shunt selon l'une des revendications précédentes, dans lequel le matériau de la première section shunt (4a) comprend ou est constitué d'un alliage Cu-Ni-Mn, de préférence du manganin.

6. Transducteur de courant shunt selon l'une des revendications précédentes, dans lequel le matériau de la deuxième section shunt (4b) est le matériau principal formant le conducteur primaire.

7. Transducteur de courant shunt selon la revendication précédente, dans lequel le matériau principal formant le conducteur primaire comprend un alliage contenant plus de 90 % de cuivre, ou comprend un alliage de cuivre et d'aluminium.

8. Transducteur de courant shunt selon l'une des revendications précédentes, dans lequel au moins l'un des ensembles de bornes comprend une pluralité de plus de cinq bornes réparties sur la largeur de la section shunt associée, sensiblement en ligne.

9. Transducteur de courant shunt selon la revendication précédente, dans lequel la pluralité de bornes d'un ensemble de bornes sont espacées de manière régulière les unes des autres.

10. Transducteur de courant shunt selon l'une ou l'autre des deux revendications directement précédentes, dans lequel tous les ensembles de bornes comprennent une pluralité de plus de cinq bornes de connexion réparties sur la largeur des sections shunt respectives orthogonalement à la direction d'écoulement du courant primaire à travers les sections shunt.

11. Transducteur de courant shunt selon l'une des trois revendications directement précédentes, dans lequel chaque borne shunt est connectée à une résistance, lesdites résistances étant connectées en parallèle à une entrée du canal de mesure respectif.

12. Transducteur de courant shunt selon l'une des revendications précédentes, dans lequel les bornes shunt comprennent des plages conductrices formées sur la carte de circuit imprimé soudée au conducteur primaire.

13. Transducteur de courant shunt selon l'une des revendications précédentes, dans lequel le conducteur primaire comprend des bornes de transducteur (6) configurées pour une connexion mécanique à des bornes correspondantes d'un conducteur primaire externe.

14. Transducteur de courant shunt selon l'une des revendications précédentes, dans lequel le conducteur primaire comprend une troisième section shunt (4c) connectée en série aux première et deuxième sections shunt (4a, 4b), facultativement dans lequel la troisième section shunt a le même matériau que la deuxième section shunt et un matériau différent de celui de la première section shunt qui est agencée entre les deuxième et troisième sections shunt.

FIG 1a

FIG 1b

FIG 1c

**FIG 2a**

Quantity to measure

Channel 1

Sensor 1

LOGIC 1

Channel 2

Sensor 2

LOGIC 2

Cross-check

Action

EP 4 575 520 B1

FIG 2b

LOGIC 1

LOGIC 2

9

10

5a
5b
5c
5d
7
12

FIG 2c

LOGIC 1

LOGIC 2

9

10

5a
5b
4a
5c
4b
5d
2

EP 4 575 520 B1

**FIG 3a**

2

4b    4a    4c

Shunt 2    Shunt 1    Shunt 3

**FIG 3b**

2

Shunt 1

4a

4b

Shunt 2

FIG 4a

FIG 4b

FIG 4c

**EP 4 575 520 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2017089955 A
- DE 102019218308
- EP 3851859 A
- DE 102021210139
- WO 2021014872 A
- DE 112019004609
- EP 2981833 A
- DE 102020111634 B3